# EUROPEAN PATENT APPLICATION

(11) **EP 4 709 064 A1**
(43) Date of publication of application: **11.03.2026**
(21) Application number: 25198853.1
(22) Date of filing: 28.08.2025
(51) Int. Cl.: H05K 1/18, H05K 3/46, H05K 3/28, H05K 3/34

(54) **CIRCUIT BOARD AND SEMICONDUCTOR PACKAGE**

(30) Priority: 06.09.2024 KR 20240121720
(71) Applicant: LG INNOTEK CO. LTD, Gangseo-gu Seoul 07796 (KR)
(72) Inventor: KWON, Ki Tae, 07796 SEOUL (KR); CHO, Hyun Dong, 07796 SEOUL (KR)
(74) Representative: Plasseraud IP

(57) **Abstract**

The present embodiment relates to a circuit board and a semiconductor package. A circuit board according to one aspect comprises a first insulating layer; a second insulating layer disposed on the first insulating layer and including a first through-hole; and a third insulating layer disposed on the second insulating layer and including a second through-hole overlapped in a direction perpendicular to the first through-hole, wherein the second insulating layer is disposed on the first insulating layer and includes a third through-hole overlapped in a direction perpendicular to the second through-hole, and the inner wall of the second through-hole overlaps at least a portion of the inner wall of the first through-hole in a vertical direction.

## Description

### [Technical Field]

The teachings in accordance with exemplary and non-limiting embodiments of the present invention relate generally to a circuit board and a semiconductor package.

### [Background Arts]

Recently, technologies related to electronic products such as Al and servers have been progressing in the direction of multi-functionality and high speed, and semiconductor chip manufacturing technology is also developing at a rapid pace to respond to this trend.

In particular, the thickness of circuit boards used to make electronic products smaller is also decreasing, and technologies related to multi-layer circuit boards that have more circuit layers in the same thickness of circuit boards are being actively researched. In addition, as the pitch of semiconductor chips is getting narrower and the size of the chips is getting larger, technologies for chiplets that separate semiconductor chips by function are being researched. In addition, technologies for connecting separated chips on a circuit board are being actively researched. In addition, technologies for connecting semiconductor chips with different functions on a circuit board are being actively researched, such as connecting semiconductor chips to each other, which was only considered from the perspective of conventional semiconductor packages.

A circuit board is a board that is formed by printing a circuit line pattern on an electrically insulating board with a conductive material such as copper, and is a general term for the board just before it is mounted with electronic components. In order to densely mount many types of electronic components on a flat panel, the mounting positions of each component are determined, and the circuit pattern that connects the components is printed on the surface of the flat panel and fixed.

Conventional embedded printed circuit boards used a drill bit to form a cavity for embedding a device, used subsidiary materials such as a release film to secure the device, or used sand blasting to form a cavity for embedding a device.

The formation of a cavity penetrating multiple insulating layers can be achieved by a process of forming a cavity in an upper insulating layer that is placed on the lower insulating layer after the formation of a cavity in the lower insulating layer. However, due to various factors such as differences in the degree of curing between multiple insulating layers, there is a problem of a thickness difference between heterogeneous insulating layers due to sagging of the upper insulating layer in the inner wall area of the cavity.

### [Related Technical Document]

### [Patent Document]

Korean laid-open patent No.10-2006-0105382 (Laid open Date: Oct. 11, 2006)

### [Summary of the Invention]

### [Technical Subject]

The present invention relates to a circuit board and a semiconductor package capable of minimizing the thickness difference between multiple insulating layers in a structure comprising a cavity penetrating multiple insulating layers.

### [Technical Solution]

A circuit board according to an exemplary embodiment of the present embodiment may comprise: a first insulating layer; a second insulating layer disposed on the first insulating layer and including a first through-hole; and a third insulating layer disposed on the second insulating layer and including a second through-hole overlapped in a direction perpendicular to the first through-hole, wherein an inner wall of the second through-hole overlaps at least a portion of the inner wall of the first through-hole in a perpendicular direction.

A semiconductor package according to an exemplary embodiment of the present invention may comprise: a first insulating layer; a second insulating layer disposed on the first insulating layer and including the first through-hole; and a third insulating layer disposed on the second insulating layer and including a second through-hole overlapped in a vertical direction with the first through-hole; and electronic elements disposed in the first through-hole and the second through-hole, wherein an inner wall of the second through-hole is overlapped at least a portion of an inner wall of the first through-hole in a vertical direction.

### [Advantageous Effects]

According to the exemplary embodiments of the present invention, there is an advantage in that the thickness difference between the multiple insulating layers can be prevented from occurring during the process of forming a cavity that penetrates the multiple insulating layers by adjusting the inner wall shape of the through holes formed in each of the multiple insulating layers.

### [Brief Descriptions of Drawings]

FIG. 1 is a cross-sectional view of a circuit board according to an embodiment of the present invention.
FIG. 2 is a drawing showing a cavity formation structure through the first insulating layer, the second insulating layer, and the third insulating layer according to an embodiment of the present invention.
FIGS. 3 and 4 are photographed drawings of the inner walls of the first and second insulating layers in the cavity formation area according to an embodiment of the present invention.
FIG. 5 is a cross-sectional view of a semiconductor package according to an embodiment of the present invention.
FIG. 6 is a drawing showing a variant example of a circuit board according to an embodiment of the present invention.
FIG. 7 shows a variant example of the cavity formation structure through the second and third insulating layers according to an embodiment of the present invention.

### [Best Modes]

Hereinafter, the attached drawings are referred to in detail to explain the preferred embodiment of the present invention.

However, the technical idea of the present invention is not limited to the some embodiments described, but can be implemented in various different forms, and within the scope of the technical idea of the present invention, one or more of the components between the embodiments can be selectively combined or replaced.

In addition, the terms used in the embodiments of the present invention (including technical and scientific terms) can be interpreted to mean what a person with ordinary skill in the art would understand, unless explicitly defined and described, and generally understood by a person with ordinary skill in the art. Generally used terms, such as those defined in dictionaries, can be interpreted in the context of the relevant technology.

In addition, the terms used in the embodiments of the present invention are intended to explain the embodiments and are not intended to limit the invention. In this specification, the singular form may include the plural form unless otherwise specified in the text, and when described as 'A and (and/and) B, C, at least one (or more than one) of A, B, and C,' it may include one or more of all combinations of A, B, and C.

In addition, terms such as 1, 2, A, B, (a), and (b) may be used to describe the components of the embodiments of the present invention.

Such terms are intended only to distinguish the component from other components and are not limited by the nature, order, or sequence of the component.

And, if any component is described as being 'connected', 'coupled' or 'attached' to another component, that component may be directly connected, coupled or attached to that other component, as well as being 'connected', 'coupled' or 'attached' to another component that is between that component and that other component.

In addition, when each component is described as being 'exposed', it should not only be exposed to the appearance of the invention as defined in the present invention, but also to other components other than that component. In other words, if it is stated that B, which is included in A, is exposed from A, it should not only mean that B is exposed to the appearance of the invention defined in the present invention, but also that it is covered by another component, C, unless there are special circumstances.

In addition, when it is stated that each component is formed or arranged 'above or below', the above or below includes not only the case where two components are directly in contact with each other, but also the case where one or more other components are formed or arranged between the two components. In addition, when it is expressed as 'upper or lower', it can include the meaning of the lower direction as well as the upper direction based on one component.

In addition, the expression that configuration A is placed between configuration B and configuration C should include the meaning that configuration A is placed so that at least part of it overlaps with configuration B and configuration C in the horizontal and/or vertical directions.

The expression referring to the direction includes the horizontal direction and the vertical direction, and the horizontal direction includes the first horizontal direction and the second horizontal direction perpendicular to the first horizontal direction. This is referred to as the first horizontal direction (X-axis), the second horizontal direction (Y-axis), and the vertical direction (Z-axis) according to the Cartesian coordinate system, and the meaning of being overlapped (superimposed) along the horizontal direction should include the meaning of being superimposed along the first horizontal direction and/or along the second horizontal direction.

In addition, one component should be based on one surface (side) and the other surface (side), which means the upper side and the lower side, or even the lower side and the upper side.

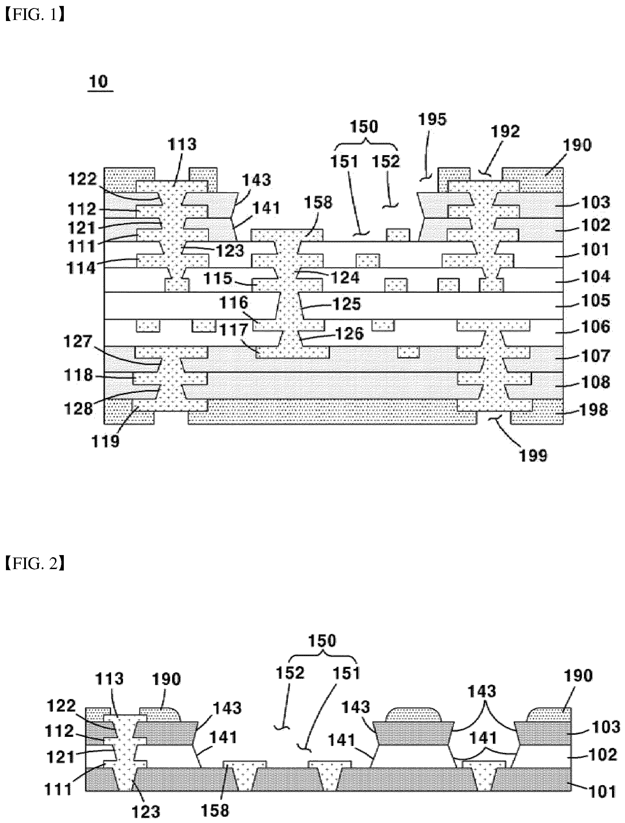

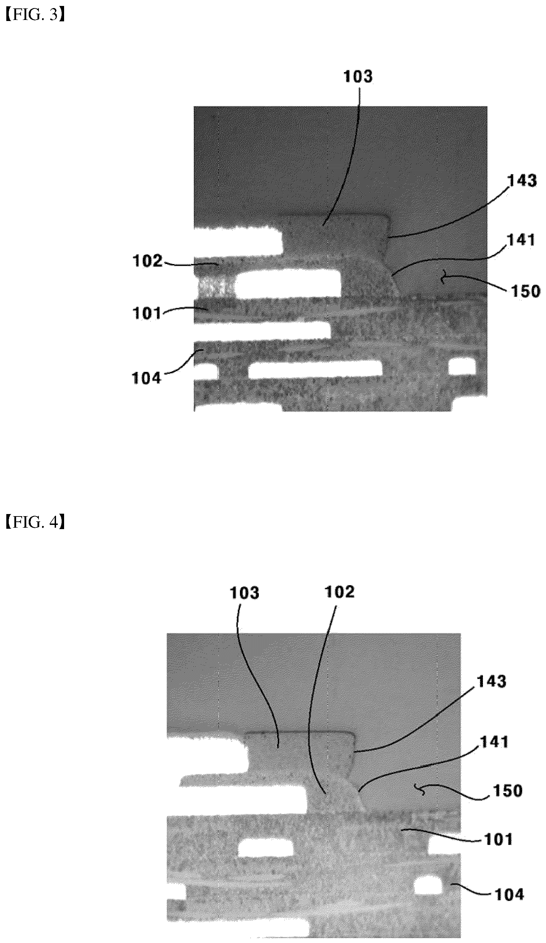

FIG. 1 is a cross-sectional view of a circuit board according to an embodiment of the present invention, FIG. 2 is a drawing showing a cavity formation structure through the first insulating layer, the second insulating layer, and the third insulating layer according to an embodiment of the present invention, and FIGS. 3 and 4 are photographed drawings of the inner walls of the first and second insulating layers in the cavity formation area according to an embodiment of the present invention.

Referring to FIGS. 1 to 4, the circuit board (10) according to an embodiment of the present invention may include a plurality of insulating layers, a plurality of wiring portions, a plurality of via portions, and a protective layer.

The circuit board (10) may include a plurality of insulating layers. The plurality of insulating layers may be disposed along a vertical direction. The plurality of insulating layers include a first insulating layer (101), a second insulating layer (102) disposed on the first insulating layer (101), a third insulating layer (103) disposed on the second insulating layer (102), a fourth insulating layer (104) disposed on the lower surface of the first insulating layer (101), The fifth insulating layer (105) disposed on the lower surface of the fourth insulating layer (104), the sixth insulating layer (106) disposed on the lower surface of the fifth insulating layer (105), the seventh insulating layer (107) placed on the underside of the sixth insulating layer (106), and an eighth insulating layer (108) disposed on the lower surface of the seventh insulating layer (108). The first to eighth insulating layers (101, 102, 103, 104, 105, 106, 107, 108) may be stacked along the vertical direction.

The first to eighth insulating layers (101, 102, 103, 104, 105, 106, 107, 108) may each be any insulator, such as a light curable and/or heat curable insulator. As thermosetting insulators, insulators with dispersed inorganic and/or organic fillers in resins such as Ajinomoto Build-up Film (ABF), a product released by Ajinomoto, and prepreg (PPG) containing glass fibres in resins may be used. In addition, the resins may be, for example, epoxy resin, bis(triazine) resin (BT resin), and phenolic resin, and the inorganic and/or organic filler may be composed of materials such as silica and plastics. If an insulating resin is used as the core, it may include reinforcing materials made of glass fibers or aramid fibers. If the first to eighth insulating layers (101, 102, 103, 104, 105, 106, 107, 108) are light-curing insulators, the first to eighth insulating layers (101, 102, 103, 104, 105, 106, 107, 108) may each be a photo imageable dielectric (PID).

In this embodiment, the core layer in the circuit board (10) is described as an example of a core-less structure, but the circuit board (10) may include a core layer. In this case, the fifth insulating layer (105) placed in the center, based on the vertical direction of the circuit board (10), may be named the core layer, and it may be formed with a thicker vertical direction thickness compared to other insulating layers to suppress the warpage of the circuit board (10).

At least some of the plurality of insulating layers may differ in material from the other insulating layers. For example, the first insulating layer (101), the fourth insulating layer (104), the fifth insulating layer (105), and the sixth insulating layer (106) disposed in the center of the vertical direction of the circuit board (10) may each be a prepreg (PPG) containing glass fibers in the resin. the second insulating layer (102) and the third insulating layer (103) disposed on the first insulating layer (101), and the seventh insulating layer (107) and the eighth insulating layer (108) disposed on the lower surface of the sixth insulating layer (106) may be a photo imageable dielectric (PID) or an Ajinomoto build-up film (ABF).

Each vertical direction thickness of first insulating layer (101), fourth insulating layer (104), fifth insulating layer (105) and sixth insulating layer (106) may be thicker than the vertical thickness of each of the second insulating layer (102), third insulating layer (103), seventh insulating layer (107) and eighth insulating layer (108). Accordingly, the deflection (warpage) of the circuit board (10) can be minimized through the first insulating layer (101), the fourth insulating layer (104), the fifth insulating layer (105) and the sixth insulating layer (106) which are disposed in the center of the vertical direction of the circuit board (10). The number of insulating layers disposed on the upper surface of the first insulating layer (101) and the number of insulating layers disposed on the lower surface of the sixth insulating layer (106) may be the same to ensure the integrity of the signal and/or power transmission, but may also be different.

The vertical thickness of each of the first insulating layer (101), the fourth insulating layer (104), the fifth insulating layer (105) and the sixth insulating layer (106) may be the same. The thickness of the vertical direction of each of the second insulating layer (102), the third insulating layer (103), the seventh insulating layer (107), and the eighth insulating layer (108) may be the same. Accordingly, it is easy to control the thickness of the electronic element to be disposed in the cavity and the depth of the cavity, which will be described later.

The circuit board (10) may include a protective layer. The protective layer may include a first protective layer (190) disposed on the upper surface of the third insulating layer (103) and a second protective layer (198) disposed on the lower surface of the eighth insulating layer (108). The first protective layer (190) and the second protective layer (198) can perform the function of preventing short circuits between the solder due to low wettability with the solder when semiconductor devices are placed on the surface of the circuit board (10) with solder or other materials, and can prevent the problem of external contaminants penetrating into the build-up structure and reducing reliability. The first protective layer (190) and the second protective layer (198) may each use a light-curable insulating material. For example, the first protective layer (190) and the second protective layer (198) may be a solder resist or a photo imageable dielectric (PID).

The first protective layer (190) may include a hole (192) for exposing a third wiring portion (113) described later to the upward side of the circuit board (10). The first protective layer (190) may include a third through-hole (195) that overlaps in a vertical direction with the cavity (150) described later. The second protection layer (198) may include a hole (199) for exposing the ninth wiring portion (119) described later to the downward side of the circuit board (10).

The circuit board (10) may include circuit patterns for transmitting electrical signals and/or power to electronic elements such as semiconductor chips. The circuit patterns may include a plurality of wiring portions and a plurality of via portions.

Multiple wiring portions may respectively be disposed on the surface of multiple insulating layers. Here, the term 'disposed on the surface' can also include the meaning that at least some of the multiple wiring portions are embedded in multiple insulating or protective layers, and are exposed from the surface. The wiring portion may also be referred to as a metal layer. In addition, the surfaces of the plurality of insulating layers may include one surface and the other surface, and the side surface between one surface and the other surface. Here, one surface of the insulating layer may be understood as the upper surface, and the other surface of the insulating layer may be understood as the lower surface. The wiring portion being disposed on the surface means that it is arranged on at least one of the one surface, the other surface, and the side surface of the plurality of insulating layers. Some of the multiple insulating layers may have wiring portions on one surface and the other surface of one of the insulation layers, and some of the multiple insulating layers may have wiring portions on one surface or the other surface of only one of the insulating layers.

The plurality of wiring portions may include a first wiring portion (111) disposed on the upper surface of the first insulating layer (101), a second wiring portion (112) disposed on the upper surface of the second insulating layer (102), and a third wiring portion (113) disposed on the upper surface of the third insulating layer (103), a fourth wiring portion (114) disposed on the upper surface of the fourth insulating layer (104), a fifth wiring portion (115) disposed on the upper surface of the fifth insulating layer (105), a sixth wiring portion (116) disposed on the lower surface of the fifth insulating layer (105), a seventh wiring portion (117) disposed on the lower surface of the sixth insulating layer (106), an eighth wiring portion (118) disposed on the lower surface of the seventh insulating layer (107), and a ninth wiring portion (119) disposed on the lower surface of the eighth insulating layer (108). Here, the third wiring portion (113) and the ninth wiring portion (119), which are at least partially covered by the protective layer (190, 198), may be referred to as the first pad portion and the second pad portion, respectively. In addition, the wiring portion may include a pad portion for connecting to a via portion.

A via portion may be a metallic material that is disposed in a via hole formed in each of a plurality of insulating layers to connect a plurality of wiring portions facing in a vertical direction. Here, the via hole penetrates at least a portion of each of the plurality of insulating layers in a vertical direction, and a via portion may be disposed in the via hole.

The via-portion may include a first via portion (123) that penetrates at least a portion of the first insulating layer (101), a second via portion (121) that penetrates at least a portion of the second insulating layer (102), and a third via portion (122) that penetrates at least a portion of the third insulating layer (103), and a fourth via portion (124) that penetrates at least a portion of the fourth insulating layer (104), a fifth via portion (125) that penetrates at least a portion of the fifth insulating layer (105), a sixth via portion (126) that penetrates at least a portion of the sixth insulating layer (106), a seventh via portion (127) that penetrates at least a portion of the seventh insulating layer (107) and an eighth via portion (128) that penetrates at least a portion of the eighth insulating layer (108).

The first via portion (123) can electrically connect the first wiring portion (111) and the fourth wiring portion (114). The second via portion (121) can electrically connect the first wiring portion (111) and the second wiring portion (112). The third via portion (122) can electrically connect the second wiring portion (112) and the third wiring portion (113). The fourth via portion (124) can electrically connect the fourth wiring portion (114) and the fifth wiring portion (115). The fifth via portion (125) can electrically connect the fifth wiring portion (115) and the sixth wiring portion (116). The sixth via portion (126) can electrically connect the sixth wiring portion (116) and the seventh wiring portion (117). The seventh via portion (127) can electrically connect the seventh wiring portion (117) and the eighth wiring portion (118). The eighth via portion (128) can electrically connect the eighth wiring portion (118) and the ninth wiring portion (119).

The first via portion (123), the second via portion (121), the third via portion (122), and the fourth via portion (124) may each have a shape in which the horizontal width becomes smaller as it goes downwards. The fifth via portion (125), the sixth via portion (126), the seventh via portion (127), and the eighth via portion (128) may have a shape in which the horizontal width increases as they move downward. Among the plurality of via portions, the fifth via portion (125) may be formed with a longer vertical length than the other via-portions. In the case of the fifth via portion (125), it is arranged to penetrate the fifth insulating layer (105) disposed in the center of the vertical direction of the circuit board (10), and the fifth wiring portion (115) and the sixth wiring portion (116) are disposed on the upper and lower surfaces of the fifth insulating layer (105), respectively, and as a result, the vertical direction length of the fifth via portion (125) may be longer than that of other via portions. In addition, the widening direction of the via portion may be reversed with respect to the fifth insulating layer (105).

The circuit board (10) may include a cavity (150). The cavity (150) may be formed by a first through-hole (151) and a second through-hole (152).

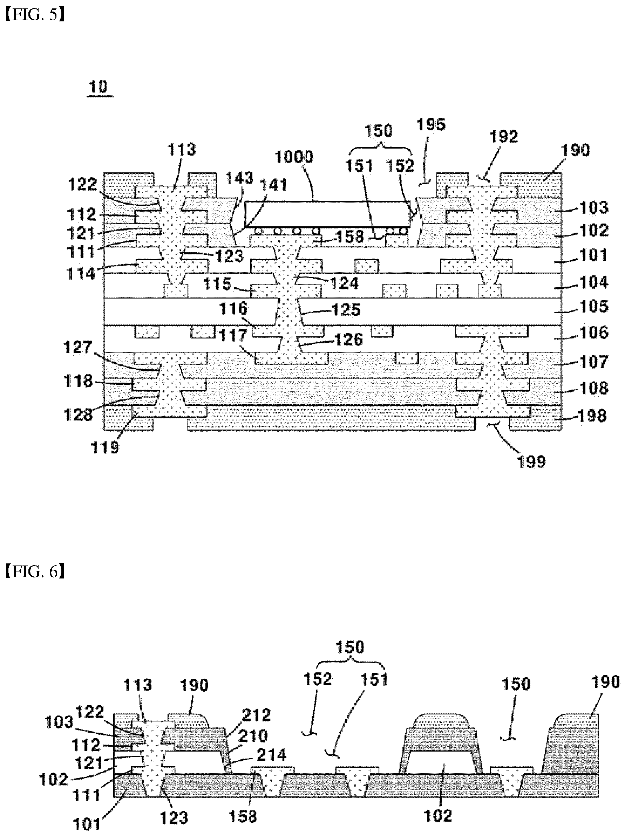

In detail, the second insulating layer (102) may include the first through-hole (151). The first through-hole (151) may be shaped to penetrate the lower surface of the second insulating layer (102) from the upper surface. The first through-hole (151) may be disposed in the center of the horizontal direction of the second insulating layer (102). For example, a portion of the upper surface of the first insulating layer (101) may be exposed from the second insulating layer (102) in the vertical direction through the first through-hole (151). The first through-hole (151) may form a placement area for the electronic element (1000, see FIG. 5) together with the second through-hole (152). In this case, a portion of the upper surface of the first insulating layer (101) may be provided as the bottom surface of the cavity to form the placement surface of the electronic element (1000).

The first through-hole (151) may have a shape in which the horizontal width gradually narrows as it faces the first insulating layer (101). Accordingly, the inner wall (141) of the first through-hole (151) may be in the shape of a slope. The inner wall (141) of the first through-hole (151) may be called the first inner wall. The first inner wall (141) may form a first angle with the upper surface of the first insulating layer (101). The first angle may be obtuse. According to an exemplary embodiment, the upper surface of the first insulating layer (101) may include one surface constituting the bottom surface of the cavity. The first angle described above refers to the angle formed by the first insulating layer (101) constituting the bottom surface of the cavity and the inner wall (141) of the first through hole constituting the inner wall of the cavity.

The third insulating layer (103) may include a second through-hole (152). The second through-hole (152) may be shaped to penetrate the lower surface of the third insulating layer (103) from the upper surface. The second through-hole (152) may be disposed in the center of the horizontal direction of the third insulating layer (103). Through the second through-hole (152), a portion of the upper surface of the first insulating layer (101) may be exposed in a vertical direction from the second insulating layer (102) and the third insulating layer (103). The second through-hole (152) may be disposed so that at least a portion of it overlaps the first through-hole (151) of the second insulating layer (102) in a vertical direction. The second through-hole (152) may form a cavity (150) with the first through-hole (151), and the electronic element (1000) may be disposed within the cavity (150).

According to one embodiment, the second through-hole (152) may have a shape in which the horizontal width gradually increases as it faces the first insulation layer (101) or the second insulation layer (102). Accordingly, the inner wall (143) of the second through-hole (152) may have a slope shape. The inner wall (143) of the second through-hole (152) may be called the second inner wall. The second inner wall (143) may form a second angle with the upper surface of the first insulating layer (101) or the upper surface of the second insulating layer (102). The second angle may be acute. According to the embodiment, the upper surface of the first insulating layer (101) may include one surface that constitutes the bottom surface of the cavity. The first angle described above refers to the angle formed by the first insulating layer (101) that constitutes the bottom surface of the cavity and the inner wall (143) of the third through hole that constitutes the inner wall of the cavity.

Accordingly, the first inner wall (141) and the second inner wall (143) may be disposed so that at least a portion of them are overlapped in the vertical direction, as shown in FIGS. 3 and 4. For example, the upper end of the second inner wall (143) may be disposed to overlap the first inner wall (141) in the vertical direction. The area where the first inner wall (141) and the second inner wall (143) meet may have a concave groove shape when viewed in a horizontal direction, compared to other areas.

As described above, a circuit board (10) according to the embodiment has a connection pad (158) disposed on the bottom surface of a cavity (150) so that the terminals of an electronic element (1000) are flip-bonded, as shown in FIG. 5. According to prior art, in the process of forming a cavity, a process of removing a portion of the second insulating layer (102) and the third insulating layer (103) using a laser or the like was used. Accordingly, an etching-inhibiting layer (undisclosed) such as copper was disposed on one surface of the first insulating layer (101) constituting the bottom surface of the cavity (150) to prevent damage to the first insulating layer (101). However, in such cases, it is difficult to connect the electronic element (1000) to the circuit board (10) by flip bonding when placing the electronic element (1000) in the cavity (150) as shown in FIG. 5, so the electronic element (1000) is mounted using a wire. In such cases, the electronic element (1000) must be mounted by forming a cavity with an area greater than the area where the electronic element (1000) is placed and the area where the wire process is possible, or by connecting the wire to the electrode on the upper part of the cavity. In such cases, the wire process itself becomes difficult to cope with the increase in the number of terminals of the electronic element (1000), or as the number of electrodes (113) exposed on the upper part of the third insulating layer (103) had to be increased to connect the electrodes (113) to the electronic device (1000) disposed in the cavity (150), and this problem requires an unnecessary increase in the area of the circuit board (10). This problem also causes a decrease in yield and an increase in material costs due to the unnecessary large-scale expansion of the circuit board (10).

The cavity (150) structure according to this embodiment is able to solve the above-mentioned problems. However, in forming a cavity (150) that penetrates the second insulating layer (102) and the third insulating layer (103) as a whole, if the inner wall (141) of the second insulating layer (102) and the inner wall (143) of the third insulating layer (103) cannot be controlled, This may cause the cavity (150) to collapse. Accordingly, the cavity (150) inner wall proposed in the present invention has a cavity (150) inner wall structure that is different from the structure of the cavity (150) using a conventional laser or the like, thereby having the effect of improving the reproducibility and yield of the circuit board (10). According to this embodiment, the problem in the comparative example can be solved because the sagging of the third insulating layer (103) can be prevented in the formation area of the cavity (150) by the structure of the inner wall of the second insulating layer (102) and the third insulating layer (103) that form the aforementioned cavity (150). In other words, the angle of the second inner wall (143) at which sagging can occur is formed at an acute angle to the upper surface of the first insulating layer (101) or the upper surface of the second insulating layer (102), and by placing the second inner wall (143) in a horizontal direction with the first inner wall (141), the thickness difference between multiple insulating layers can be minimized in the formation area of the cavity (150).

In addition, when placing the molding member (not shown) for embedding the electronic element (1000) in the cavity (150), the bonding strength with the molding member can be improved by the various angles of the first inner wall (141) and the second inner wall (143).

In addition, according to the shape of the second inner wall (143), the cross-sectional area of the upper end of the second through-hole (152) is smaller than the cross-sectional area of the lower part of the second through hole (152), so by forming a small area of the cavity for the placement of the electronic element (1000), it is possible to increase the degree of freedom in the design of the electrodes (113) required for mounting other electronic elements (not shown) and/or other circuit boards (not shown) on the circuit board (10).

Based on the electronic element (1000) disposed within the cavity (150), the first inner wall (141) may have a shape that the horizontal distance to the side surface of the electronic element (1000) becomes closer as it goes downward. The second inner wall (143) may have a shape in which the horizontal distance to the side surface of the electronic element (1000) becomes longer as it goes downwards.

Although not shown, the surface connecting the upper surface of the third insulating layer (103) and the second inner wall (143) may be formed in a round shape. In this case, the surface connecting the upper surface of the third insulating layer (103) and the second inner wall (143) may be named the round surface. The strength of the third insulating layer (103) can be reinforced in the area connecting the upper surface of the third insulating layer (103) and the second inner wall (143) through the round surface.

As shown in FIGS. 3 and 4, at least a portion of the first inner wall (141) or the second inner wall (143) may include a curved surface. At least a portion of the curved surface may protrude outward from the surface of the first inner wall (141) or the second inner wall (143). Accordingly, the strength of the second insulating layer (102) and the third insulating layer (103) can be reinforced in the formation area of the cavity (150).

Meanwhile, the second inner wall (143) may form a right angle with the upper surface of the first insulating layer (101) or the upper surface of the second insulating layer (102). In this case, the first inner wall (141) may be exposed at least partially upward to the third insulating layer (103). In this case, there is an advantage in that the area for placing the electronic element (1000) in the cavity (150) is enlarged in contrast to the shape of the second inner wall (143) described above.

In the area where the first through-hole (151) and the second through-hole (152) meet, the horizontal width of each of the first through-hole (151) and the second through-hole (152) may be mutually the same.

As shown in FIG. 4, at least a portion of the third insulating layer (103) may be disposed on the first inner wall (141) so as to cover the first inner wall (141). In addition, at least a portion of the third insulating layer (103) may be disposed on the first inner wall (141) to cover a portion of the curved surface if the first inner wall (141) has a curved surface. In this case, the shape of the cavity (150) can be prevented from collapsing by preventing the concentration of stress that occurs between the first inner wall (141) and the third insulating layer (103), thereby improving the reliability of the circuit board (10).

At least a portion of the third insulating layer (103) may be disposed closer to the first insulating layer (101) than the upper surface of the second insulating layer (102). In other words, the vertical length from the bottom surface of the second inner wall (143) to the bottom surface of the cavity (150) may be shorter than the vertical length of the second insulating layer (102). Accordingly, the bending of the circuit board (10) due to an increase in the contact area between the second insulating layer (102) and the third insulating layer (103) can be minimized, and the upper end of the second inner wall (143) can be prevented from sagging downward in the formation area of the cavity (150).

As mentioned above, the first protective layer (190) may include a third through-hole (195) that overlaps at least a portion of the cavity (150) in a perpendicular direction. In this case, the horizontal width of the third through-hole (195) may be larger than the horizontal width of the first through-hole (151) or the second through-hole (152). Accordingly, at least a portion of the upper surface of the first insulating layer (101) forming the bottom surface of the cavity (150) through the third through-hole (195), the inner wall (141) of the first through-hole (151), and the upper surface of the third insulating layer (103) may be exposed upward of the first protective layer (190).

FIG. 5 is a cross-sectional view of a semiconductor package according to an embodiment of the present invention.

As shown in FIG. 5, the semiconductor package may include an electronic element (1000) that is disposed in a cavity (150) within a circuit board (10). A connection pad (158) that provides an electrical connection to the electronic element (1000) may be disposed on the bottom surface of the cavity (150). The connection pad (158) may be disposed on the upper surface of the first insulating layer (101). The electronic element (1000) may be coupled to the connection pad (158).

The connecting pad (158) may be disposed in a superimposed manner in a horizontal direction with the first wiring portion (111). The connecting pad (158) may be disposed in a superimposed manner in a horizontal direction with the first inner wall (141). The first inner wall (141) of the first through-hole (151) and the connecting pad (158) may be spaced apart in the horizontal direction. Accordingly, in the process of bonding the electronic element (1000) on the connecting pad (158), the damage to the electronic element (1000) by the first inner wall (141) can be minimized. In addition, the space can be secured to allow the bubbles between an adhesive member and the electronic element (1000) to be discharged during the process of bonding the electronic element (1000) through the adhesive member (not shown) described later through the separation area. The above-described embodiment is the case where the bottom surface of the cavity (150) includes at least a portion of the first insulating layer (101), and not limited to this, if another insulating layer is disposed between the first insulating layer (101) and the second insulating layer (102), the width of the connecting pad (158) can be made wider than the width of the first through-hole (151) to prevent recesses from occurring on the surface of the other insulating layer, thereby preventing the formation of a spacing area.

An adhesive member (not shown) may be added between the connecting pad (158) and the electronic element (1000). The electronic element (1000) may be bonded to the connection pad (158) by means of a conductive bonding member. The conductive bonding member may be solder, solder paste, etc.

According to prior art, when forming a cavity (150) for placing an electronic element (1000), an etching resist (resistant) layer (not shown) using a metal such as copper (Cu) is disposed on the bottom surface of the cavity (150), and the etching resist layer (not shown) and the electronic element (1000) were bonded together through an adhesive material such as a die attach film (DAF). However, in such cases, the electrical connection between the electronic element (1000) and the circuit board (10) is buried by forming an additional build-up layer on top of the cavity (150), or the electronic element (1000) could be mounted on the circuit board (10) by connecting the electrodes of the electronic element (1000) to the electrodes (113) exposed outside the cavity (150) of the circuit board (10) using wires. In such cases, there was a disadvantage that the width of the cavity (150) had to be excessively wide, or there was a limit to wire connection when the number of terminals of the electronic element (1000) increased. Therefore, the cavity (150) manufacturing method of the present invention proposes a structure in which the lower surface of the cavity (150) is not provided with an etching-resist layer (not shown), but rather, a patterned electrode (158) is placed so that the electronic element (1000) can be flip-bonded.

A molding member (not shown) is placed inside the cavity (150) so that the bonded (coupled) state of the electronic element (1000) inside the cavity (150) can be maintained firmly. The upper surface of the molding member may be exposed above the first protective layer (190), but alternatively, the first protective layer (190) may be disposed to cover the upper surface of the molding member.

FIG. 6 is a drawing showing a variant example of a circuit board according to an embodiment of the present invention.

In the variant example, the other parts are the same as the above-mentioned embodiments, except for the difference in the inner wall structure due to the formation of the cavity.

Referring to FIG. 6, the third insulating layer (103) may include a protrusion (210). In other words, a second through-hole (152) may be formed in the third insulating layer (103) disposed on the inside of the first through-hole (151) of the second insulating layer (102). The protrusion (210) of the third insulating layer (103) may have a shape in which at least a portion protrudes downward. The protrusion (210) may be disposed in a superimposed (overlapped) manner in a horizontal direction with the second insulating layer (102). The protrusion (210) may be shaped to wrap around the side surface of the second insulating layer (102). The lower end of the protrusion (210) may be connected to the upper surface of the first insulating layer (101).

According to the exemplary embodiment, in controlling the depth of the cavity (150), the method of laminating the second insulating layer (102) and the third insulating layer (103) can be used. In other words, one can choose to form a single cavity using a thick insulating layer, but the current panel-level exposure technology, the degree of curing of the insulating layer to light, and the coefficient of thermal expansion rate (CTE) considering the delamination of the insulating layer during the process by the method, it is more advantageous in terms of yield and reliability to form a cavity (150) by laminating (stacking) a thin insulating layer. Therefore, the second insulating layer (102) and the third insulating layer (103) may have a thickness that is thinner than the thickness of the insulating layer that is disposed on the lower surface of the first insulating layer (101) and the first insulating layer (101).

In addition, according to the embodiment, if a second through-hole (152) is formed in the third insulating layer (103) disposed on the inside of the first through-hole (151) of the second insulating layer (102), the second insulating layer (102) supports the third insulating layer (103), This can prevent the phenomenon of the third insulating layer (103) collapsing. In such cases, the inclination angle of the inner wall of the first through-hole (151) can be arranged to have a different inclination angle from that of the inner wall of the second through-hole (152), thereby improving the mechanical strength of the cavity (150). For example, the inclination angle of the inner wall of the second through-hole (152) may be more gradual than the inclination angle of the inner wall of the first through-hole (151), which may have a structure that is advantageous for dispersing stress.

By means of the above structure, the inner wall of cavity (150) can be formed by the third insulating layer (103). The inner wall of the cavity (150) may include a lower region (214) that overlaps the second insulating layer (102) in a horizontal direction, and an upper region (212) that is disposed on the lower region (214) and does not overlap the second insulating layer (102) in a horizontal direction.

According to this variant example, since the inner wall of cavity (150) is implemented by a single insulating layer, it is possible to prevent the occurrence of a thickness difference due to sagging when forming a cavity that penetrates multiple insulating layers. In addition, it has the advantage of increasing the bonding strength between heterogeneous insulating layers with a multi-surface bonding structure through the protrusion (210).

In addition, the structure of the cavity formation through a single insulating layer makes it easier to secure cavity space, and has the advantage of preventing eccentricity from occurring during the cavity formation process between heterogeneous insulating layers.

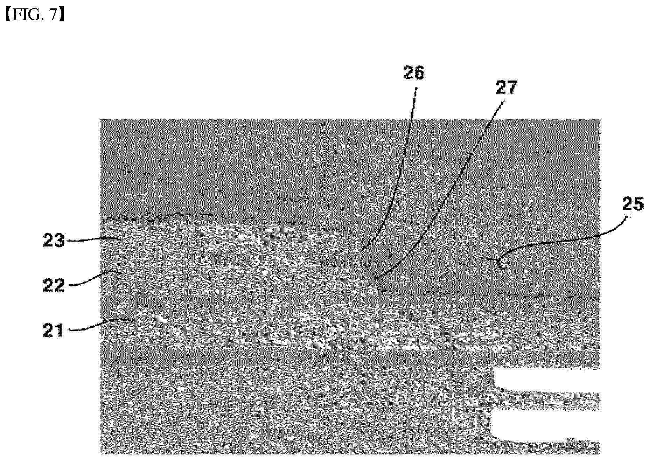

FIG. 7 is a drawing showing a variant example of cavity formation structure through the second and third insulating layers according to an exemplary embodiment of the present invention. Referring to FIG. 7, a first insulating layer (21), a second insulating layer (22), and a third insulating layer (23) are vertically stacked, and in the process of forming a cavity (25), a first through-hole can be formed within the second insulating layer (22), and a second through-hole within the third insulating layer (23) can be formed on the inside of the first through-hole.

In the formation region of the cavity (25) including the inner wall (26) of the second through-hole, the second insulating layer (22) and the third insulating layer (23) may include regions having different thicknesses in the vertical direction due to sagging of the third insulating layer (23).

In the above, it is not necessarily limited to this embodiment, even though all components constituting the embodiment of the present invention are described as being combined or operated by combining them into one. In other words, within the scope of the present invention, all of its components may be selectively combined and operated by one or more. In addition, the terms 'include', 'comprise' or 'have' as used herein should be interpreted to mean that the component may be inherent, unless specifically stated otherwise, and not to exclude other components, but rather to include other components. All terms, including technical or scientific terms, have the same meaning as would be understood by a person with ordinary skill in the art to which the invention pertains, unless otherwise defined. Terms that are commonly used, such as those defined in dictionaries, should be interpreted in accordance with their meaning in the context of the relevant art, and not in an idealized or overly formal sense, unless explicitly defined in the invention.

The above description is merely an illustrative example of the technical idea of the present invention, and those skilled in the art to which the present invention belongs will be able to make various modifications and variations within the scope that does not deviate from the essential characteristics of the present invention. Therefore, the embodiments disclosed in the present invention are not intended to limit the technical idea of the present invention, but are intended to explain it, and the scope of the technical idea of the present invention is not limited by these embodiments. The scope of protection of the present invention should be interpreted by the following claims, and all technical ideas within the scope of the equivalent thereof should be interpreted as being included in the scope of the present invention.

Meanwhile, when a circuit board with the features of the above-mentioned invention is used in IT devices or home appliances such as smartphones, server computers, and TVs, it can perform functions such as signal transmission or power supply stably. For example, if a circuit board with the features of the present invention performs the function of a semiconductor package, it can function to safely protect the semiconductor chip from external moisture or contaminants, and can solve problems of leakage current or electrical short circuit between terminals or electrical opening of the terminals supplying the semiconductor chip. In addition, if it is responsible for signal transmission, it can solve the problem of noise. This allows the circuit board with the features of the above-described invention to maintain the stable function of IT devices or home appliances, thereby achieving functional integrity or technical interoperability between the entire product and the circuit board to which the invention is applied.

When a circuit board with the above-mentioned features of the invention is used in a transportation device such as a vehicle, it is possible to solve the problem of signal distortion transmitted to the transportation device, or to safely protect the semiconductor chip that controls the transportation device from the outside, and to further improve the stability of the transportation device by solving the problem of leakage current or electrical short circuit between terminals or the electrical opening of the terminals supplying the semiconductor chip. Therefore, the transport device and the circuit board to which the present invention is applied can achieve functional integrity or technical interoperability.

## Claims

1. A circuit board comprising:
a first insulating layer;
a second insulating layer disposed on the first insulating layer and including a first through-hole; and
a third insulating layer disposed on the second insulating layer and including a second through-hole that overlaps the first through-hole in a vertical direction,
wherein an inner wall of the second through-hole overlaps at least a portion of the inner wall of the first through-hole in the vertical direction.

2. The circuit board of claim 1, wherein the inner wall of the first through-hole and an upper surface of the first insulating layer form a first angle, and the inner wall of the second through-hole and an upper surface of the first insulating layer form a second angle different from the first angle.

3. The circuit board of claim 2, wherein the first angle and the second angle are respectively within 180 degrees

4. The circuit board of claim 2, wherein the first angle is obtuse, and the second angle is acute.

5. The circuit board of claim 2, wherein the first angle is obtuse, and the second angle is right.

6. The circuit board of claim 1, wherein the first through-hole has a shape that gradually becomes narrower in width as it approaches the first insulating layer, and the second through-hole has a shape that gradually increases in width as it approaches the first insulating layer.

7. The circuit board of claim 1, wherein the materials of the first insulating layer and the second insulating layer are different, and the materials of the second insulating layer and the third insulating layer are the same.

8. The circuit board of claim 7, wherein the second insulating layer and the third insulating layer are each Photo Imageable Dielectric (PID).

9. The circuit board of claim 7, wherein the first insulating layer is prepreg (PPG).

10. The circuit board of claim 1, wherein a surface connecting an upper surface of the third insulating layer and an inner wall of the second through-hole is a round surface.

11. The circuit board of claim 1, wherein a thickness of the first insulating layer is greater than a thickness of the second insulating layer or a thickness of the third insulating layer.

12. The circuit board of claim 1, wherein at least a portion of the first inner wall and the second inner wall includes a curved surface.

13. The circuit board of claim 1, wherein at least a portion of the third insulating layer is disposed on the surface of the first inner wall.

14. The circuit board of claim 13, wherein at least a portion of the third insulating layer is overlapped (superimposed) in a horizontal direction with the second insulating layer.

15. The circuit board of claim 1, wherein the third insulating layer includes a protrusion, and the protrusion is overlapped (superimposed) in a horizontal direction with the second insulating layer.
